# EUROPEAN PATENT SPECIFICATION

(11) **EP 0 411 905 B1**
(45) Date of publication and mention of the grant of the patent: **10.03.1993**
(21) Application number: 90308419.2
(22) Date of filing: 31.07.1990
(51) Int. Cl.: H03L 7/093, H04N 5/12

(54) **Phase locked loop oscillating circuit**
Oszillatorschaltung mit Phasenregelkreis
Circuit oscillateur à boucle de verrouillage de phase

(30) Priority: 31.07.1989 JP 199743/89
(43) Date of publication of application: 06.02.1991
(73) Proprietor: SHARP KABUSHIKI KAISHA, Osaka 545 (JP)
(72) Inventor: Mizukata, Katsuya, Tenri-shi, Nara-ken (JP); Takeda, Makoto, Nara-shi, Nara-ken (JP); Take, Hiroshi, Ikoma-shi, Nara-ken (JP); Kawaguchi, Takafumi, Nara-shi, Nara-ken (JP)
(74) Representative: Brown, Kenneth Richard

(56) References cited:
- WO-A-88/08644
- DE-A- 2 436 711
- DE-B- 1 275 166
- FR-A- 2 116 432

## Description

The present invention relates to a phase locked loop circuit, called hereinafter a PLL circuit, as for example described in WO 88/08644

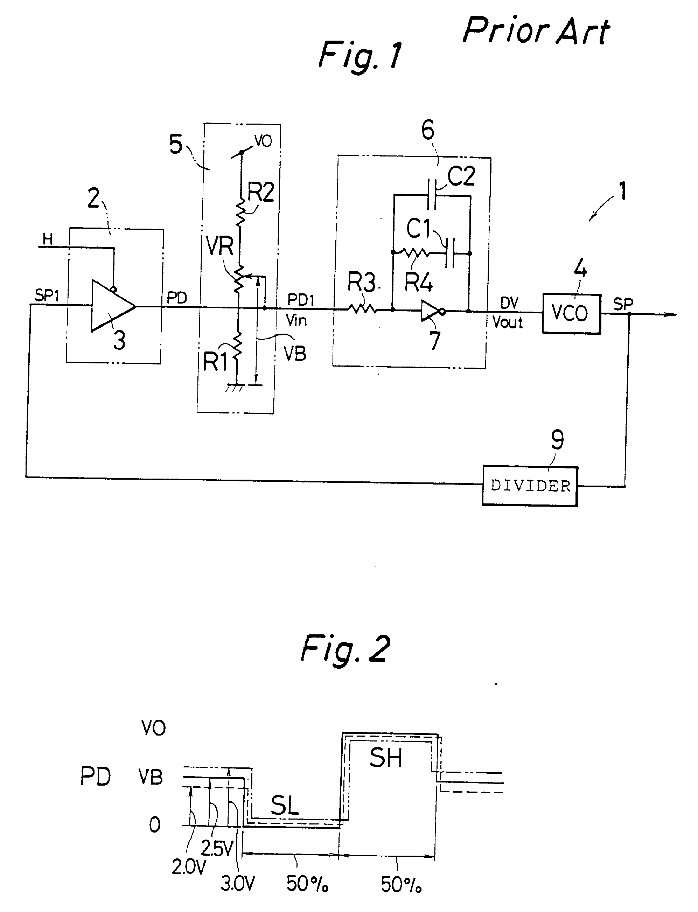

A conventional TV receiver uses a PLL circuit to generate pulses synchronous with the horizontal synchronizing signal included in the received composite video signal, by adjusting the frequency of the PLL circuit oscillator so as to correct for any phase variation in the horizontal synchronizing signal. Fig. 1 shows a block diagram of a typical conventional PLL circuit 1. The PLL circuit 1 is provided with a phase comparator circuit 2, to which, for example, a horizontal synchronizing signal H, separated from the received video signal, is fed. This phase comparator circuit 2 is equivalent to a three-state buffer 3, which is fed with synchronizing pulses SP1 obtained by dividing with a divider 9 the synchronizing pulse output SP of a voltage-controlled oscillator (called hereinafter oscillator) 4. The phase comparator 2 produces a signal PD whose duty cycle is dependent on the phase difference between its two input signals H and SP1, according to the truth table of Table 1.

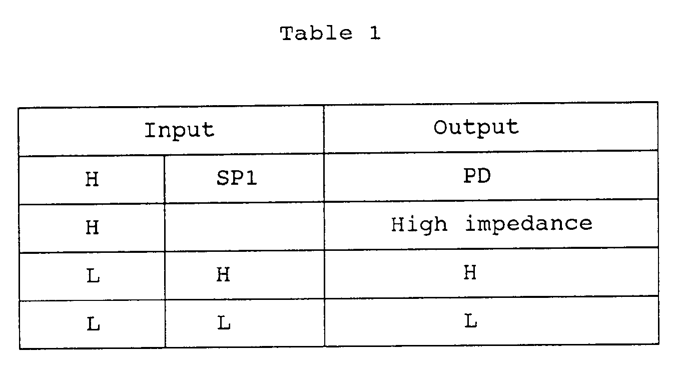

The phase difference signal PD is fed to a mute adjusting circuit 5, which converts the signal into a phase difference signal PD1, as described later, and feeds it to an active low-pass filter (called hereinafter LPF) 6, where the high frequency components are removed to produce a difference voltage DV. The difference voltage DV is used to control the frequency of the oscillator 4. The mute adjusting circuit 5 has a resistance R1, a variable resistor VR, and a resistance R2 connected in series as shown between a reference voltage VO (for example, 5V) and ground. The output PD of the phase comparator 2 is connected to the wiper of the variable resistor VR.

The LPF 6 includes a resistance R3 connected at one end in series with an inverter 7 and at the other end to the wiper of the variable resistor VR of the circuit 5. A series-connected resistance R4 and capacitor C1 and a capacitor C2 are connected in parallel with the inverter 7. The inverter 7 is suitably a CMOS integrated circuit.

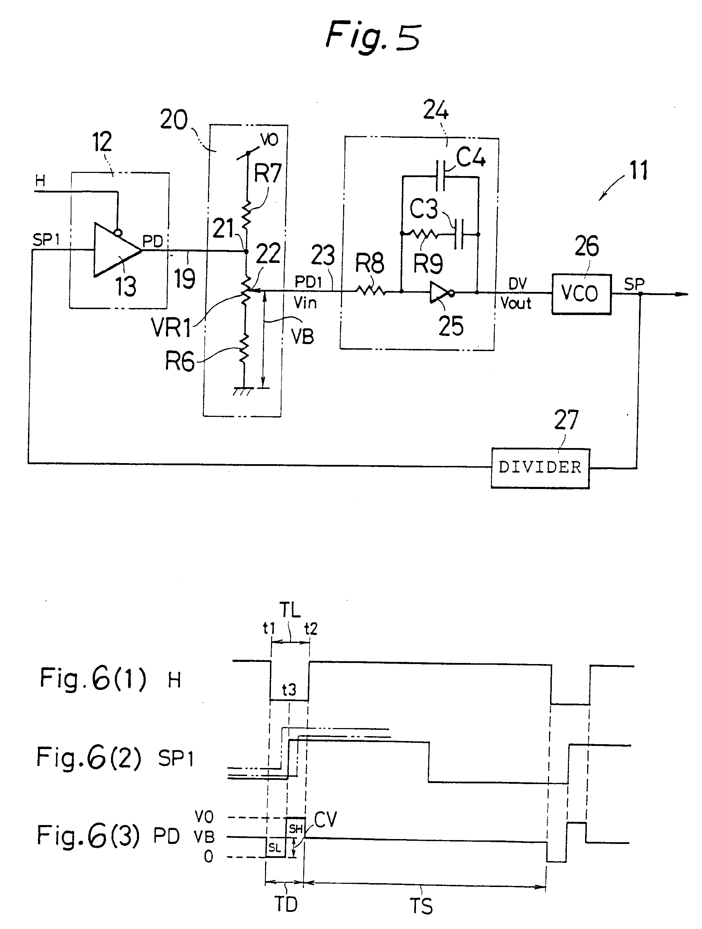

The fundamental operation of the phase comparator circuit 2 is shown by the signal waveforms in Fig. 6. The phase difference signal PD in Fig. 6(3) is obtained by subjecting the level of the synchronizing pulse SP1, while synchronizing signal H in Fig. 6(1) is at Low level, to the level change indicated in Table 1. While the synchronizing signal H is at High level, the three-state buffer 3 will be in its high impedance condition, and the phase difference signal PD is thus set to the level of the bias voltage VB determined by the mute adjusting circuit 5.

If there is no phase difference between the synchronizing pulse SP1 and synchronizing signal H, that is when the synchronizing pulse SP1 is switched over from Low to High level at time t3, mid-way between the start (at time t1) and the finish (at time t2) of the Low level period TL of the synchronizing signal H (Fig. 6(1)), the phase difference signal PD contains pulses of 50% duty as shown in Fig. 2. The centre value (CV) of the phase difference signal PD has the same level as the bias voltage VB (2.5V) if the bias voltage is selected to be VO/2=2.5V by means of the variable resistor VR.

In these circumstances, the PLL circuit 1 has the same duty in its range below the bias voltage VB as the one above it, and thus the same correctable frequency range is available whether the frequency of the synchronizing signal H varies from this condition to the high frequency side or to the low frequency side.

However, since the Low/High level input threshold voltage of the CMOS inverter 7, and thus the input/output characteristics of the LPF 6, will vary from device to device, the mute adjusting circuit 5 permits the bias voltage VB of the phase difference signal PD1 to be adjusted appropriately.

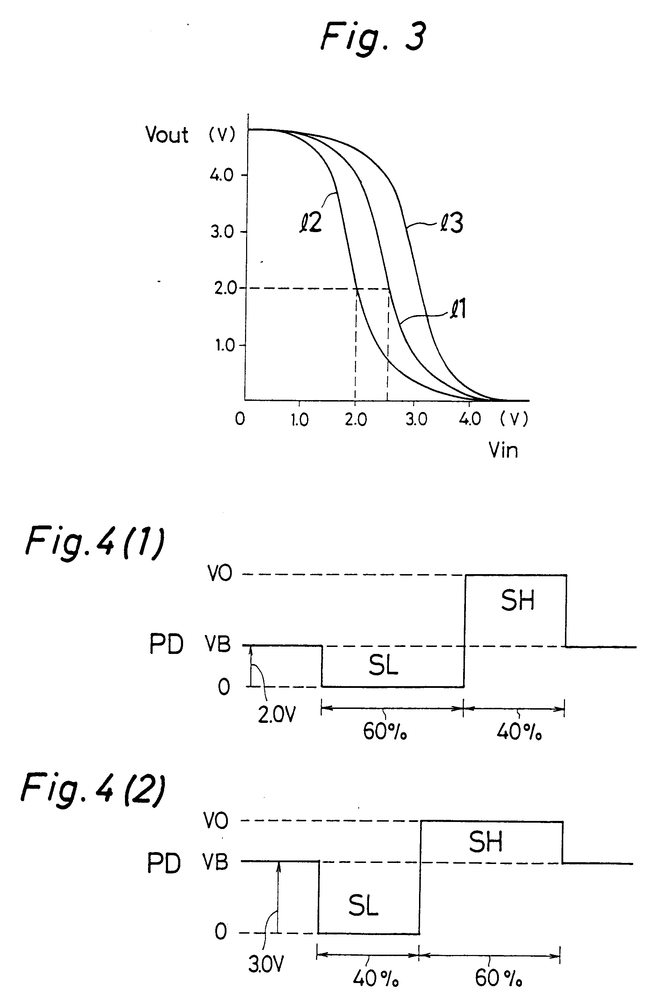

Fig. 3 shows typical input/output voltage transfer characteristics for an LPF 6 having a CMOS inverter circuit 7. The line ℓ1 represents that of a device having an ideal threshold voltage, while the lines ℓ2 and ℓ3 represent devices having low and high threshold voltages respectively. When an integrated circuit having the ideal threshold of line ℓ1 is used in the LPF 6, setting the centre value (CV) of the phase difference signal PD1 (and, therefore, the input voltage Vin) to 2.5V will produce an output voltage Vout of 2.0V.

In contrast, for an integrated circuit having the characteristic of line ℓ2 to produce the same output voltage Vout=2.0V involves adjustment for the input voltage Vin to 2.0V by the mute adjusting circuit 5. By this adjustment of the bias voltage VB to 2.0V the phase difference signal PD1 acquires the waveform shown by the regular broken line in Fig. 2. Accordingly, the area SH of the portion of the signal PD above the new bias voltage VB=2.0V becomes larger than the area SL below the bias voltage VB. As a result, the output frequency of the oscillator 4 will vary to cause delay of the synchronizing pulse SP1 relative to the synchronizing signal H, as shown by the two-dotted chain line in Fig. 6(2). This gives the phase difference signal PD the same area SL below the new bias voltage VB=2.0V as the area SH above it, as indicated in Fig. 4(1), so that the oscillator 4 now outputs synchronizing pulses SP which are synchronous with the synchronizing signal H.

Similarly, for an integrated circuit having the characteristic of line ℓ3 in Fig. 3 to produce the same output voltage Vout=2.0V involves adjustment for the input voltage Vin to 3.0V by the mute adjusting circuit 5. By this adjustment of the bias voltage VB to 3.0V the phase difference signal PD acquires the waveform shown by the two-dotted chain line in Fig. 2. Accordingly, the area SL of the portion of the signal PD below the new bias voltage VB=3.0V becomes larger than the area SH above the bias voltage VB. As a result, the output frequency of the oscillator 4 will vary to cause advance of the synchronizing pulse SP1 relative to the synchronizing signal H, as shown by the three-dotted chain line in Fig. 6(2). This gives the phase difference signal PD the same area SL below the new bias voltage VB=3.0V as the area SH above it, as indicated in Fig. 4(2), so that the oscillator 4 now outputs synchronizing pulses SP which are synchronous with the synchronizing signal H.

Significantly, the phase difference signal PD with the waveform indicated in Fig. 4(1) differs from that shown by the solid line in Figure 2 in that the duties of the portions below and above the bias voltage VB are 60% and 40% respectively. The phase difference signal PD with the waveform indicated in Fig. 4(2) likewise differs in that the duties of the portions below and above the bias voltage VB are 40% and 60% respectively. In both cases, the PLL circuit 1 thus provides a different correction range according to whether the synchronizing signal H shifts to a higher frequency or a lower frequency than the synchronizing pulse SP1. Consequently, the use of this type of PLL circuit in, for example, a TV receiver does not always permit attainment of the correction range necessary for varying the horizontal line frequency within specified limits, leading to the generation of turbulence in the picture.

The present invention aims to provide a PLL circuit in which the range of correctable mutual phase variation between the reference signal and the phase-locked signal is uniform whether the PLL oscillator frequency needs to be increased or decreased.

In accordance with the invention, a phase-locked loop circuit having a voltage-controlled oscillator, a signal comparing means receiving an input reference signal and a feedback signal from the oscillator for generating a control signal the duty cycle of which determines the oscillator frequency, a signal converting means feeding the control signal from the signal comparing means to the oscillator, and a level converting means coupling the signal comparing means to the signal converting means for setting the level of the control signal to suit the voltage transfer characteristics of the signal converting means, is characterized in that the level converting means changes both the amplitude and the level of the control signal in such a manner that the level adjustment does not result in a change in the duty cycle of the control signal.

Other and further objects, features and advantages of the invention will be more explicit from the following detailed description taken with reference to the drawings, wherein:

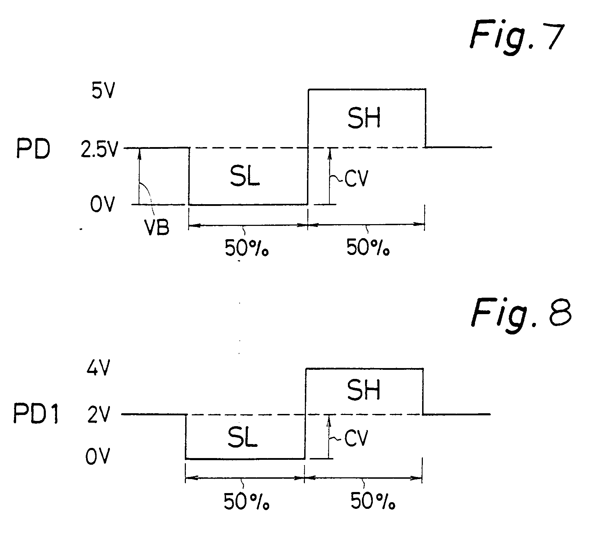

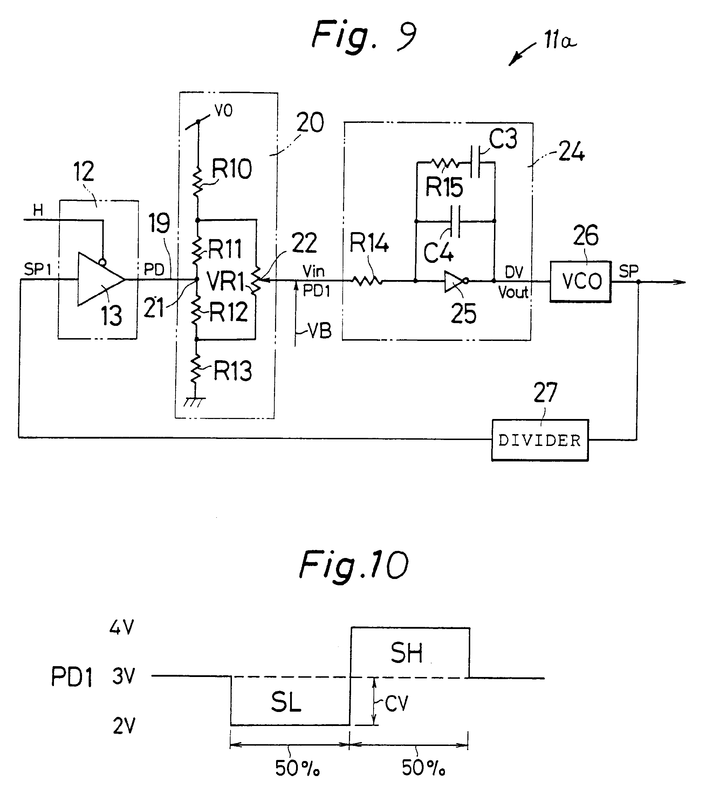

Fig. 1 is a block diagram typically illustrating the configuration of a conventional PLL circuit 1, while Fig. 2 shows a waveform relevant to the operation of PLL circuit 1. Fig. 3 is a graph indicating typical threshold voltage characteristics of the inverter 25 in Fig. 5 and the inverter 7 in Fig. 1. Fig. 4 shows waveforms illustratively describing the operation of a conventional PLL circuit. Fig. 5 is a block diagram presenting the configuration of a PLL circuit 11 in one preferred embodiment of the invention, while Fig. 6 is a time chart exhibiting the operation of the phase comparators 12 and 2 in Fig. 5 and Fig. 1 respectively. Figs. 7 and 8 show waveforms describing the operation of the same embodiment of the invention. Fig. 9 is a block diagram presenting the configuration of a PLL circuit 11a in another preferred embodiment of the invention and Fig. 10 shows a waveform relevant to its operation.

One embodiment of a PLL circuit 11 in accordance with the invention will now be described, by way of example only, with reference to the block diagram of Fig. 5. For conciseness, elements of the circuit 11 which are identical to the corresponding elements of the prior art circuit of Figure 1 will not be described. Thus, the phase comparator 12, LPF 24, VCO 26 and divider 27 are identical to the corresponding, differently labelled, components of the Figure 1 circuit.

The invention, and the present embodiment is characterised by the replacement of the mute adjusting circuit 5 of the prior art circuit (Figure 1) with a level converting circuit 20. The level converting circuit 20 consists of a resistance R6, a variable resistor VR1, and another resistance R7 connected in series as shown between a reference voltage VO (for example, 5V) and ground. The circuit 20 has an input line 19 which connects the phase comparator to the junction 21 between resistance R7 and variable resistor VR1, and an output line 23 which connect the slider 22 of variable resistor VR1 to the LPF 24.

Referring additionally to Fig. 6, in, for example, a TV receiver application of the PLL circuit 11, a synchronizing signal H (Fig. 6 (1)), such as the horizontal synchronizing signal separated from the received composite video signal, is fed to the phase comparator 12, while the synchronizing pulse SP1 (Fig. 6 (2)), obtained by dividing with the divider 27 the synchronizing pulse SP1 from the output of the oscillator 26, is fed as a second input to phase comparator 12.

The phase comparator 12 operates as described already according to the truth table of Table 1. Accordingly, the phase comparator 12 generates a phase difference signal PD with, for example, a minimum value of 0V, a maximum value of VO (5V), and, therefore, a centre value CV, i.e. a time-averaged, of mean value VO/2 (=2.5V), see Fig. 6(3). In the period TD in Fig. 6(3) the phase difference signal PD has a duty cycle which varies in dependence upon the phase difference between the synchronizing signal H and synchronizing pulse SP, while in the period TS the bias voltage VB set by the level converting circuit 20 is maintained.

The LPF 24 produces an output difference voltage DV having a level dependent upon the duty cycle, about the centre value CV, of the phase difference signal PD. Thereby the oscillator 26 generates a synchronizing pulse SP with a frequency dependent upon the difference voltage DV, and is fed back as the frequency-divided synchronizing pulse SP1 to the phase comparator 12.

When a difference voltage DV of 2.0V is desired and the inverter 25 has the ideal threshold voltage characteristic of line ℓ1 in Fig. 3, the centre value CV of the phase difference signal PD1 as output from the level converting circuit 20 must be set to 2.5V. In the circuit shown in Fig. 5, the resistance value of R6 is set to 3 kΩ, the total resistance value of VR1 to 2 kΩ, and the resistance value of R7 to 5.1 kΩ. If the slider 22 is then set so as to be connected to the junction 21, the phase difference signal PD will have an amplitude of 2.5V, a centre value CV of 2.5V, and a bias voltage VB of 2.5V, as shown in Fig. 7.

Because the slider 22 is connected to the junction 21, the phase difference signal PD1 is identical to the phase difference signal PD. In this condition, the area of the portion SL below the centre value 2.5V is identical to that of the portion SH above it, the duty being 50%. Whether the synchronizing signal H moves from this condition to the high frequency side or the low frequency side, the PLL circuit 11 will have the same correction range, in which the oscillator 26 generates a synchronizing pulse SP with a frequency varying according to the changing phase of the synchronizing signal H.

If the inverter 25 has a relatively low threshold voltage, as shown, for example, by the line ℓ2 in Fig. 3, on the other hand, the centre value CV of the phase difference signal PD1 must be set to 2.0V. In the level converting circuit 20, therefore, the slider 22 must be shifted from the junction 21 toward the ground potential.

When the slider 22 is connected to the junction 21, the centre value CV = 2.5V is provided by the combined resistance value 5kΩ of the resistance R6 and the total resistance value of VR1. To achieve a centre value CV=2.0V, the resistance value R required between the slider 22 and ground may be calculated as follows:$\text{R=} \frac{\text{2V x 5kΩ}}{\text{2.5V}} \text{= 4.0kΩ}$

Therefore, the amplitude of the phase difference signal PD in this embodiment is compressed by the level converting circuit 20 by the ratio 5:4, to give a phase difference signal PD1 as shown in Fig. 8.

With this phase difference signal PD1, the area of the portion SL below the new centre value CV=2V remains equal to that of the portion SH above it. This prevents occurrence of the problem of the prior art circuit by which the duty cycle of the phase difference signal PD deviates from 50% when the bias voltage VB is changed, as was described with reference to Figs. 2 and 4.

It will be appreciated that the embodiment of Figure 5 described above may be modified to similarly overcome the problem of a relatively high inverter threshold voltage, for example, as shown by line ℓ3 in Fig. 3. In this case, variable resistor VR1 and resistance R7 in Fig. 5 may be combined so that the voltage on the slider 22 may be raised above 2.5V.

Fig. 9 is a block diagram of PLL circuit 11a according to another embodiment of the invention. This embodiment has a similar configuration to the Figure 5 embodiment, corresponding parts being given the same reference symbols. Explanation of the corresponding parts is eliminated. The characteristic feature of this embodiment lies in the form of the level converting circuit 20. The level converting circuit 20 comprises resistances R10, R11, R12, R13 connected in series and a variable resistor VR1 whose fixed resistance is connected in parallel with the series-connected resistances R11 and R12, as shown in Fig. 9. The chain of resistances R10 - R13 is connected between a reference voltage VO (for example, 5V) and ground. The output of phase comparator 12 is connected to the junction 21 of resistances R11 and R12, whilst the slider 22 of variable resistor VR1 is again connected to the input of LPF 24.

When a difference voltage DV of 2.0V is desired and the inverter 25 has the ideal threshold voltage characteristic of line ℓ1 in Fig. 3, the centre value CV of the phase difference signal PD1 as output from the level converting circuit 20 must be set to 2.5V. In the circuit shown in Fig. 9, the values of resistances R10 - R13 are set to 1 kΩ, 10 kΩ, 10 kΩ and 1 kΩ, respectively, and VR1 to 1 kΩ. The slider 22 is then adjusted to the centre position of the fixed resistance of variable resistor VR1. The potential at slider 22 will then equal that of the fixed potential 2.5V at junction 19, so that the phase difference signal PD will have an amplitude of 2.5V, a centre value CV of 2.5V, and a bias voltage VB of 2.5V, as shown in Fig. 7. The area of the portion SL below the centre value 2.5V is identical to that of the portion SH above it, the duty cycle of signal PD being 50%. Whether the synchronizing signal H moves from this condition to the high frequency side or the low frequency side, the PLL circuit 11a will have the same correction range, in which the oscillator 26 generates a synchronizing pulse SP with a frequency varying according to the changing phase of synchronizing signal H.

If the inverter 25 has a relatively high threshold voltage, as shown, for example, by the line ℓ3 in Fig. 3, on the other hand, the centre value CV of the phase difference signal PD1 must be set to 3.0V. In the level converting circuit 20, therefore, the slider 22 must be moved until VB = 3.0V, the available range being between a minimum potential of 1.7V and a maximum potential of 3.3V for the particular resistance values given above.

The effect of the level converting circuit 20 is that the amplitude of the phase difference signal PD in this embodiment is compressed to provide a phase difference signal PD1 as shown in Fig. 10. In this phase difference signal PD1, the area of the portion SL below the new centre value CV = 3V remains equal to that of the region SH above it. This prevents occurrence of the aforementioned problem of the prior art circuit by which the duty cycle of the phase difference signal PD deviates from 50% when the bias voltage VB is changed.

It will be appreciated that the PLL circuit 11a of Figure 9 is equally suited to the case of an inverter having a relatively low threshold voltage, for example, as shown by line ℓ2 in Fig. 3.

## Claims

1. A phase-locked loop circuit having a voltage-controlled oscillator (26), a signal comparing means (12) receiving an input reference signal (H) and a feedback signal (SP1) from the oscillator (26) for generating a control signal the duty cycle of which determines the oscillator frequency, a signal converting means (24) feeding the control signal from the signal comparing means (12) to the oscillator (26), and a level converting means (20) coupling the signal comparing means to the signal converting means for setting the level of the control signal to suit the voltage transfer characteristics of the signal converting means, characterized in that said level converting means (20) changes both the amplitude and the level of the control signal in such manner that the level adjustment does not result in a change in the duty cycle of the control signal.

2. A phase locked loop circuit according to claim 1, wherein said level converting means (20) comprises potentiometer means having a fixed potential terminal (21) to which the output of the signal comparing means (12) is connected (19), and an adjustable potential terminal (22) to which the input of the signal converting means (24) is connected (23), the voltage at the adjustable potential terminal determining said level of the control signal.

3. A phase-locked loop circuit according to claim 2, wherein said potentiometer means comprises a variable resistor (VR1) having its two fixed resistance terminals connected respectively to a predetermined reference potential (VO) via a first fixed resistor (R7) and to a ground potential via a second fixed resistor (R6), the junction of said first resistor with said variable resistor constituting said fixed potential terminal (21) and the wiper of said variable resistor constituting said adjustable potential terminal (22).

4. A phase-locked loop circuit according to claim 2, wherein the voltage at the adjustable potential terminal (22) of said potentiometer means can be adjusted between two reference voltages, respectively higher and lower than the voltage at the fixed potential terminal (21).

5. A phase-locked loop circuit according to claim 4, wherein said potentiometer means comprises four resistors (R10-R13) connected in series between a predetermined reference potential (V0) and a ground potential, and a variable resistor (VR1) whose fixed resistance is connected in parallel with the middle two resistors (R11, R12) of said four resistors, the common connection point of said middle two resistors constituting said fixed potential terminal (21) and the wiper of said variable resistor constituting said adjustable potential terminal (22).

6. A phase-locked loop circuit according to any one of the preceding claims, wherein said signal converting means is a low-pass filter (24) which comprises a CMOS inverter (25).

7. A phase-locked loop circuit according to any one of the preceding claims, wherein said signal comparing means comprises a phase comparator (12) for comparing the phase of a synchronising signal (H) separated from an input complex video signal with that of said feedback signal (SP1) to produce said control signal of duty cycle dependent upon the detected phase difference.

8. A phase-locked loop circuit according to any one of the preceding claims, including a divider circuit (27) which generates said feedback signal (SP1) from the output (SP) of said oscillator (26).

## Patentansprüche

1. Phasenregelkreis mit einem spannungsgeregelten Oszillator (26), einer Signal-Vergleichseinrichtung (12), die ein Eingangsreferenzsignal H und ein Rückkopplungssignal (SP1) von dem Oszillator (26) zum Erzeugen eines Regelsignals empfängt, dessen Tastverhältnis die Oszillatorfrequenz bestimmt, einer Signal-Umwandlungseinrichtung (24), welche das Regelsignal von der Signal-Vergleichseinrichtung (12) an den Oszillator (26) führt und einer Pegel-Umwandlungseinrichtung (20), welche die Signal-Vergleichseinrichtung (12) zum Einstellen des Pegels des Regelsignals mit der Signal-Umwandlungseinrichtung (24) verbindet, um den Spannungs-Übertragungseigenschaften der Signal-Umwandlungseinrichtung (24) zu entsprechen, ***dadurch gekennzeichnet***, daß die Pegel-Umwandlungseinrichtung (20) die Amplitude und den Pegel des Regelsignals in einer Weise verändert, daß die Pegeleinstellung keine Änderung im Tastverhältnis des Regelsignals zur Folge hat.

2. Phasenregelkreis nach Anspruch 1, in dem die Pegel-Umwandlungseinrichtung (20) eine Potentiometereinrichtung mit einem festen Potentialanschluß (21), an den der Ausgang (19) der Signal-Vergleichseinrichtung (12) angeschlossen ist, und einem einstellbaren Potentialanschluß (22), an den der Eingang (23) der Signal-Umwandlungseinrichtung (24) angeschlossen ist, enthält, wobei die Spannung an dem einstellbaren Potentialanschluß den Pegel des Regelsignals bestimmt.

3. Phasenregelkreis nach Anspruch 2, in dem die Potentiometereinrichtung einen variablen Widerstand (VR1) enthält, dessen zwei feste Widerstandsanschlüsse der Reihe nach über einen ersten Festwiderstand (R7) mit einem bestimmten Referenzpotential (VO) und über einen zweiten Festwiderstand (R6) mit einem Massepotential verbunden sind, wobei die Verbindung des ersten Widerstandes mit dem variablen Widerstand den festen Potentialanschluß (21) und der Schleifer des variablen Widerstands den einstellbaren Potentialanschluß (22) bildet.

4. Phasenregelkreis nach Anspruch 2, in dem die Spannung an dem einstellbaren Potentialanschluß (22) der Potentiometereinrichtung zwischen zwei Referenzspannungen eingestellt werden kann, die höher oder niedriger als die Spannung an dem festen Potentialanschluß (21) sind.

5. Phasenregelkreis nach Anspruch 4, in dem die Potentiometereinrichtung vier Widerstände (R10-R13), die zwischen einem bestimmten Referenzpotential (VO) und einem Massepotential in Reihe geschaltet sind, und einen variablen Widerstand (VR1), dessen fester Widerstand parallel zu den mittleren beiden Widerständen (R11, R12) der vier Widerstände geschaltet ist, enthält, wobei der gemeinsame Anschlußpunkt der mittleren beiden Widerstände den festen Potentialanschluß (21) und der Schleifer des variablen Widerstandes den einstellbaren Potentialanschluß (22) bildet.

6. Phasenregelkreis nach einem der vorangehenden Ansprüche, in dem die Signal-Umwandlungseinrichtung ein Tiefpaßfilter (24) mit einem CMOS-Inverter (25) ist.

7. Phasenregelkreis nach einem der vorangehenden Ansprüche, in dem die Signal-Vergleichseinrichtung einen Phasenkomparator (12) zum Vergleichen der Phase eines von einem komplexen Eingangs-Videosignal getrennten Synchronsignals (H) mit der des Rückkopplungssignals (SP1), um das Regelsignal mit dem von der ermittelten Phasendifferenz abhängigen Tastverhältnis zu erzeugen.

8. Phasenregelkreis nach einem der vorangehenden Ansprüche, der eine Teilerschaltung (27) zum Erzeugen des Rückkopplungssignal (SP1) aus dem Ausgang (SP) des Oszillators (26) enthält.

## Revendications

1. Circuit à boucle de verrouillage de phase ayant un oscillateur commandé en tension (26), un moyen de comparaison de signaux (12) recevant un signal de référence d'entrée (H) et un signal de réaction (SP1) en provenance de l'oscillateur (26) pour générer un signal de commande dont le rapport cyclique détermine la fréquence de l'oscillateur, un moyen de conversion de signaux (24) envoyant le signal de commande en provenance du moyen de comparaison de signaux (12) à l'oscillateur (26), et un moyen de conversion de niveau (20) reliant le moyen de comparaison de signaux au moyen de conversion de signaux pour régler le niveau du signal de commande de façon à ce qu'il convienne aux caractéristiques de transfert de tension du moyen de conversion de signaux, caractérisé en ce que ledit moyen de conversion de niveau (20) modifie tant l'amplitude que le niveau du signal de commande de telle manière que l'ajustement de niveau n'aboutisse pas à une modification du rapport cyclique du signal de commande.

2. Circuit à boucle de verrouillage de phase selon la revendication 1, dans lequel ledit moyen de conversion de niveau (20) comprend un moyen formant potentiomètre ayant une borne de potentiel fixe (21) à laquelle la sortie du moyen de comparaison de signaux (12) est reliée (19), et une borne à potentiel réglable (22) à laquelle l'entrée du moyen de conversion de signaux (24) est reliée (23), la tension au niveau de la borne à potentiel réglable déterminant ledit niveau du signal de commande.

3. Circuit à boucle de verrouillage de phase selon la revendication 2, dans lequel ledit moyen formant potentiomètre comprend une résistance variable (VR1) dont les deux bornes à résistance fixe sont reliées respectivement à un potentiel de référence prédéterminé (VO) via une première résistance fixe (R7) et à un potentiel de terre via une seconde résistance fixe (R6), la jonction entre ladite première résistance et ladite résistance variable constituant ladite borne à potentiel fixe (21) et le curseur de ladite résistance variable constituant ladite borne à potentiel réglable (22).

4. Circuit à boucle de verrouillage de phase selon la revendication 2, dans lequel la tension au niveau de la borne à potentiel réglable (22) dudit moyen formant potentiomètre peut être réglée entre deux tensions de référence qui sont respectivement supérieure et inférieure à la tension au niveau de la borne à potentiel fixe (21).

5. Circuit à boucle de verrouillage de phase selon la revendication 4, dans lequel ledit moyen formant potentiomètre comprend quatre résistances (R10 à R13) reliées en série entre un potentiel de référence prédéterminé (VO) et un potentiel de terre, et une résistance variable (VR1) dont la résistance fixe est reliée en parallèle avec les deux résistances médianes (R11, R12) desdites quatre résistances, le point de connexion commun desdites deux résistances médianes constituant ladite borne à potentiel fixe (21) et le curseur de ladite résistance variable constituant ladite borne à potentiel réglable (22).

6. Circuit à boucle de verrouillage de phase selon l'une quelconque des revendications précédentes, dans lequel ledit moyen de conversion de signaux est un filtre passe-bas (24) qui comprend un inverseur CMOS (25).

7. Circuit à boucle de verrouillage de phase selon l'une quelconque des revendications précédentes, dans lequel ledit moyen de comparaison de signaux comprend un comparateur de phase (12) pour comparer la phase d'un signal de synchronisation (H), séparé d'un signal vidéo complexe d'entrée, à celle dudit signal de réaction (SP1) pour produire ledit signal de commande dont le rapport cyclique est fonction de la différence de phase détectée.

8. Circuit à boucle de verrouillage de phase selon l'une quelconque des revendications précédentes, comprenant un circuit diviseur (27) qui génère ledit signal de réaction (SP1) à partir de la sortie (SP) dudit oscillateur (26).
